(19) **Europäisches Patentamt European Patent Office Office européen des brevets**

(11) **EP 4 782 859 A1**

(12) # EUROPEAN PATENT APPLICATION

(43) Date of publication:
**29.07.2026 Bulletin 2026/31**

(21) Application number: **25153719.7**

(22) Date of filing: **24.01.2025**

(51) International Patent Classification (IPC):
**G01R 31/52** $^{(2020.01)}$ **H02H 3/33** $^{(2006.01)}$
**H02H 1/00** $^{(2006.01)}$

(52) Cooperative Patent Classification (CPC):
**H02H 3/33; G01R 31/52;** H02H 1/0007

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ABB SCHWEIZ AG 5400 Baden (CH)**

(72) Inventors:
• **BUTTI, Agostino 20151 Milano (IT)**
• **CURRA, Antonio 20081 Abbiategrasso (MI) (IT)**

(74) Representative: **De Bortoli, Eros et al Zanoli & Giavarini S.p.A. Via Melchiorre Gioia, 64 20125 Milano (IT)**

(54) **A RESIDUAL CURRENT DEVICE**

(57) The present invention relates to a residual current device (500) for low-voltage electrical systems. The residual current device (500) comprises:
- a detection stage (2) that, in operation, is coupled to an electric line (100), wherein said detection stage (2) is configured to detect a residual current in said electric line (500) and provide a detection signal (V(t)) indicative of said residual current;
- an electronic stage configured to receive and process said detection signal;

The electronic stage (3) comprises a signal processing unit (30) configured to process said detection signal (V(t)) and, possibly, determine whether the electric line is subject to an earth leakage fault. According to further aspects, the present invention relates to a method for detecting a residual current in an electric line (100) and a method for determining the presence of an earth leakage fault in an electric line (100).

**FIG. 1**

EP 4 782 859 A1

**Description**

The present invention relates to the field of residual current detection solutions for low-voltage electrical systems. More particularly, the present invention relates to a residual current device, which can be employed, for example, in electronic protection devices against earth leakage faults or in monitoring devices designed to monitor residual currents.

As is known, residual current devices are electronic devices designed to detect residual currents in an electric line and, possibly, determine whether earth leakage fault conditions are present in the electric line based on the behaviour of the detected residual currents.

A typical residual current device comprises a detection stage, which is configured to detect a residual current between the conductors of an electric line, and an electronic stage, which is configured to process the detection data incoming from the detection stage and generate a trip signal or an alarm signal, if the measured residual current exceeds certain predefined threshold values, or more simply, generate a monitoring signal indicative of the detected residual current. In more conventional residual current devices, the above-mentioned electronic stage basically includes analog electronic circuits. This solution has the undoubted advantage of being quite cheap to manufacture industrially and entailing relatively low energy consumption levels.

Unfortunately, the electronic stages of this type have some relevant drawbacks.

Generally, they are characterised by a naturally limited flexibility in use as their functionalities are necessarily restricted to their circuit structure.

Additionally, they are typically configured to measure the peak value of the detected residual current. Their performance is thus strongly influenced by the actual waveform of the detected residual current. If the waveform of this latter is strongly distorted, an earth leakage fault may be wrongly determined based on the detected residual current, which may lead to an undesired interruption of the electric line.

In the attempt of solving these drawbacks, most recent residual current devices, such as the one disclosed in EP2208271B 1, have been equipped with electronic stages including a digital signal processing device, for example a microcontroller.

In principle, the arrangement of a digital signal processing device affords a greater flexibility in use for the electronic stage, particularly in relation to the implementation of auxiliary or dedicated functionalities.

Additionally, electronic stages including a digital signal processing can easily implement algorithms based on the calculation of more specific parameters related to the detected residual current (such as the RMS value) to determine the presence of an earth leakage fault in an electric line. This ensures a higher accuracy in determining a fault condition and the possibility of implementing advanced tripping strategies for the electric line, whenever necessary.

A relevant drawback of the electronic stages of this type consists in that the algorithms commonly used to process the detection data provided by the detection stage are relatively complex and cumbersome to be carried out.

The onboard digital signal processing device must thus have a relatively high calculation power to ensure an optimal performance of the residual current device. Therefore, the electronic stage may be an expensive and energy consuming component of the residual current device, which may have a significant impact on the overall design and industrial costs of the electronic protection device or monitoring device employing the residual current device.

The main aim of the present invention is to produce a residual current device for low-voltage electrical systems, which allows the above-described drawbacks to be overcome or mitigated. Within the scope of this aim, another object of the present invention is to provide a residual current device, which has a considerable flexibility in use and can greatly favour the implementation of advanced tripping strategies.

Another object of the present invention is to provide a residual current device, which shows a high operational reliability, which can greatly favour a reduction of undesired tripping interventions in an electric line.

Another object of the present invention is to provide a residual current device, which is characterised by relatively low power consumption and is relatively easy and cheap to manufacture at industrial level.

The above main aim and objects, as well as other objects that will become apparent from the following description and attached drawings, are achieved according to the invention by a residual current device, according to the following claim 1 and the related dependent claims. Characteristics and advantages of the present invention will emerge more clearly from the description given below, referring to the attached figures, which are given as a non-limiting example, wherein:

-    figure 1 schematically illustrates an electronic protection device including the residual current device, according to the present invention;
-    figure 1A schematically illustrates a monitoring device including a residual current device, according to the present invention;
-    figures 2-8 schematically show some signal processing functionalities carried out by a digital signal processing unit included in the residual current device, according to the invention. With reference to the above-mentioned figures, the present invention concerns a residual current device 1 for low-voltage electrical systems, i.e. operating at low-voltage levels, for example lower than 1,5 kV AC.

The residual current device 1 may be advantageously employed in electronic protection devices against earth leakage faults in electric lines or in monitoring devices designed to monitor residual currents in electric lines. These latter devices are commonly used in low-voltage electric grids, electric switchgear systems, electric switchboards, and the like.

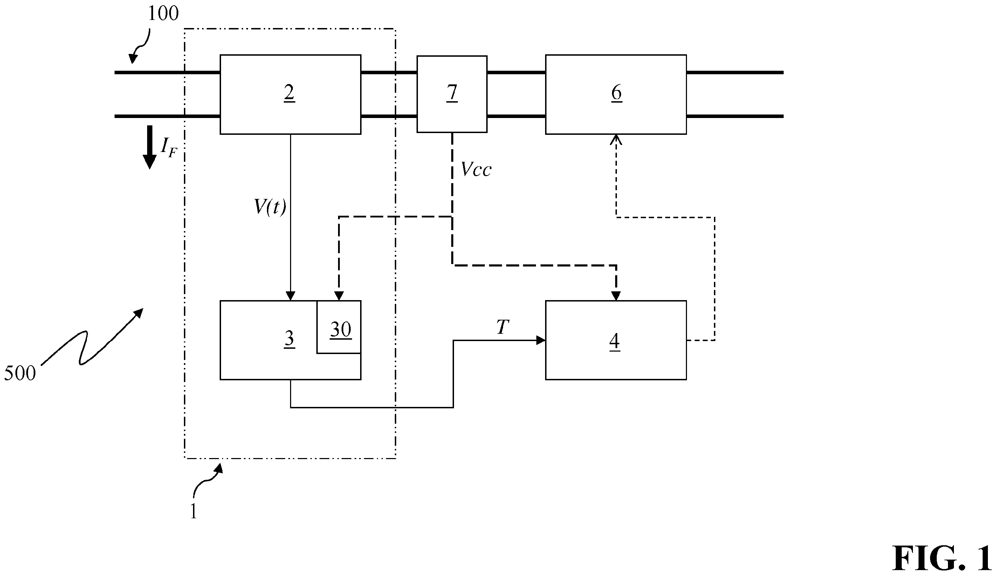

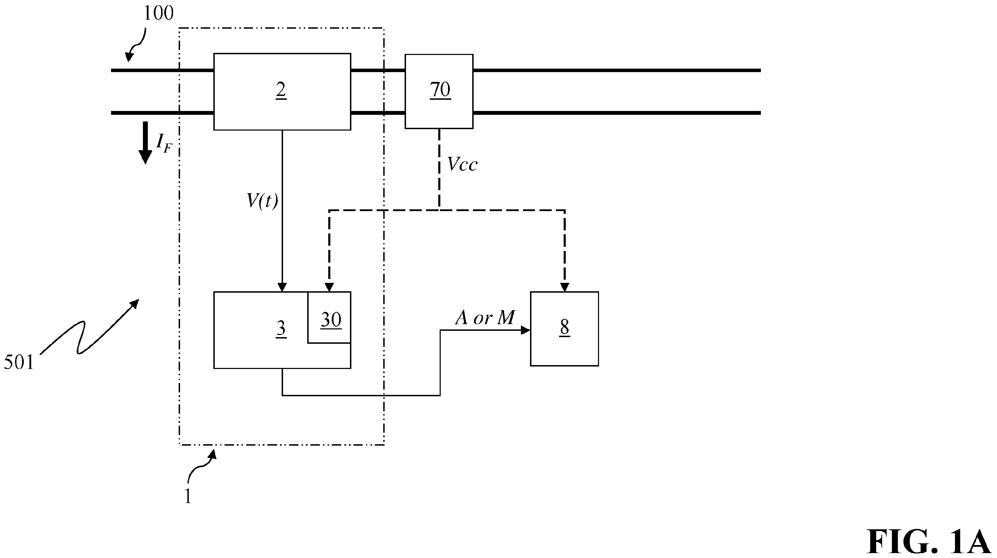

Figure 1 shows an electronic protection device 500 designed to protect an electric line 100 against an earth leakage fault, i.e., an operating condition characterised by the presence of dangerous earth leakage currents in the electric line.

The electronic protection device 500 may be, for example, a RCCB (Residual Current Circuit Breaker), or a RCBO (Residual Current circuit Breaker with Overcurrent protection), or the like. Preferably, the electronic protection device 500 is a RCCB or RCBO of the F-type.

As widely known, RCBBs and RCBOs are protection devices operating according to standards IEC 61008 and IEC 61009, respectively. RCCBs or RCBOs of the F-type are protection devices that can react to residual currents having a frequency up to 1 kHz (much higher than the mains frequency 50-60 Hz) and are particularly robust against undesired tripping events, according to standard IEC 62423.

In operation, the electronic protection device 500 is operatively coupled to the electric line 100, which can comprise one or more phase conductors and, possibly, also a neutral conductor. As an example, it may be arranged according to a 1P+N configuration, a 3P configuration, a 3P+N configuration, or a 2P+N configuration, and so on.

The electronic protection device 500 comprises one or more pairs of electric contacts 6, which, in operation, are electrically connected to corresponding conductors of the electric line 100. Each pair of electric contacts 6 are adapted to be mutually coupled or separated from one another in such a way to control a current flow along the electric line.

In operation, the electronic protection device 500 can take a closed state, in which the electric contacts 6 are mutually coupled to allow the flow of a current along the electric line 100, or can take an open or tripped state, in which the electric contacts 6 are separated to interrupt the electric line 100 and prevent a current to flow along this latter.

A transition from a closed state to an open or tripped state forms an opening manoeuvre or a tripping manoeuvre of the electronic protection device while a transition from an open or tripped state to a closed state forms a closing manoeuvre of the electronic protection device.

In general terms, the electronic protection device 500 is designed to carry out a tripping manoeuvre, if a leakage earth fault is determined to be present in the electric line 100.

For the sake of clarity, it is again specified that an earth leakage fault occurs when dangerous earth leakage currents are present in the electric line.

As for traditional solutions of the state of the art, the electronic protection device 500 is designed to determine the presence of an earth leakage fault by detecting a residual current $I_F$ (unbalance current) between a plurality of conductors of an electric line 100 and checking whether the detected residual current exceeds certain predefined threshold values, which are normally calculated in compliance with accepted technical standards and define the so-called *"tripping characteristic curve"* of the electronic protection device.

The electronic protection device 500 comprises a residual current device 1, according to the invention, which is operatively coupled to the electric line 100.

The residual current device 1 is capable of detecting a residual current $I_F$ (unbalance current) between a plurality of conductors (for example a phase conductor and a neutral conductor) of the electric line and determine whether the electric line 100 is subject to an earth leakage fault based on the behaviour of the detected residual current. If it determines that an earth leakage fault is present, the residual current device 1 generates a trip signal $T$.

The electronic protection device 500 comprises an actuating stage 4 operatively coupled to the electric line 100 to actuate the electric contacts 6.

In operation, the actuating stage 4 causes the separation of the electric contacts 6 in such a way to interrupt the electric line 100 in response to receiving the trip signal $T$ provided by the residual current device 1.

Preferably, the assembly including the actuating stage 4 and the electric contacts 6 constitutes an electromechanical relay included in the electronic protection device 500.

Preferably, the electronic protection device 500 comprises an auxiliary power supply stage 7 electrically connected to the electric line 100 and configured to harvest the electric power necessary to feed the residual current device 1, the actuating stage 4 and other possible electronic circuits of the electronic protection device from the electric line 100.

In general, the electric line 100, the actuating stage 4, the electric contacts 6 and the power supply stage 7 of the electronic protection device 500 may be realized according to solutions of known type. Therefore, in the following, these components will not be described in further details for the sake of brevity.

Figure 1A shows an electronic monitoring device 501 designed to monitor the operating conditions of an electric line 100.

The monitoring device 501 comprises a residual current device 1 according to the invention, which is operatively coupled to the electric line 100.

According to some embodiments of the invention, the residual current device 1 is capable of detecting a residual current $I_F$ (unbalance current) between a plurality of conductors of the electric line 100 and determine whether the electric line is subject to an earth leakage fault based on the behaviour of the detected residual current. If it determines that an earth leakage fault is present in the electric line 100, the residual current device 1 generates an alarm signal A.

According to other embodiments, the residual current device 1 is designed to carry out simpler monitoring functionalities of the residual current. In this case, the residual current device 1 is capable of detecting a residual current $I_F$ (unbalance current) between a plurality of conductors of the electric line 100 and generate a monitoring signal $M$ indicative of the detected residual current.

The monitoring device 501 may include an additional electronic stage 8 to process the signals A or M provided in output by the residual current device 1, e.g., for signalling purposes.

Preferably, the monitoring device 501 comprises an auxiliary power supply stage 70 electrically connected to the electric line 100 and configured to harvest the electric power necessary to feed the residual current device 1, the possible further electronic stage 8 and other possible electronic circuits of the monitoring device 501 from the electric line 100.

In general, the electric line 100, the further electronic stage 8, and the power supply stage 70 of the electronic monitoring device 501 may be realized according to solutions of known type. Therefore, in the following, these components will not be described in further details for the sake of brevity.

Referring to both figures 1, 1A described above, according to the invention, the residual current device 1 comprises a detection stage 2 operatively coupled to the electric line 100.

The detection stage 2 is capable of detecting a residual current $I_F$ (unbalance current) between a plurality of conductors of the electric line and providing a detection signal $V(t)$ indicative of the detected residual current.

The detection signal $V(t)$ is indicative of the instantaneous trend of the residual current $I_F$, in other words of the magnitude of the residual current over time.

Preferably, the detection stage 2 includes a current transformer having a plurality of conductors (for example a phase conductor and a neutral conductor) of the electric line 100 as primary windings and a secondary winding electrically connected to a sensing circuit (e.g., of the resistive type) having output terminals, at which the detection signal $V(t)$ is made available.

Preferably, the detection signal $V(t)$ is a voltage signal in such a way to favour its processing by suitable signal processing resources arranged in cascade to the detection stage 2.

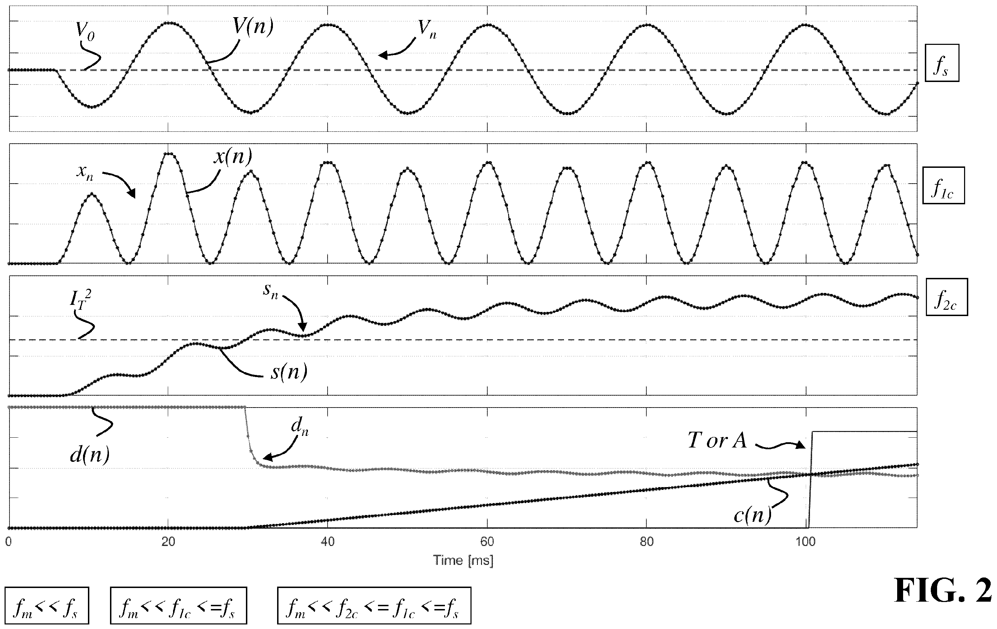

The detection signal $V(t)$ may have an offset value $V_0$, which depends on the power supply voltage $V_{CC}$ used to feed the detection stage 2. For example, the offset value may be $V_0 = V_{CC}/2$ (figures 1, 1A, 2).

The detection signal $V(t)$ is not necessarily a sinusoidal signal as shown in figure 2. As an example, it may vary in magnitude and frequency over time.

According to the invention, the electronic protection device 1 comprises an electronic stage 3 electrically connected to the detection stage 2.

In operation, the electronic stage 3 receives and processes the detection signal $V(t)$ incoming from the detection stage 2.

According to some embodiments of the invention, the electronic stage 3 provides in output a monitoring signal $M$ indicative of the detected residual current $I_F$. In principle, the monitoring signal may be any kind of signal suitable for providing information concerning the trend of the detected residual current $I_F$. As an example, the monitoring signal M may be a digital signal. According to some embodiments of the invention, the electronic stage 3 can also determine whether the electric line 100 is subject to an earth leakage fault based on the detection signal $V(t)$, i.e. based on the trend of the detected residual current $I_F$.

The electronic stage 3 provides a trip signal $T$ or an alarm signal $A$, if it determines that electric line 100 is subject to an earth leakage fault.

In principle, the trip signal $T$ or the alarm signal $A$ may be any kind of signal suitable for providing information concerning the determined operating conditions of the electric line.

As an example, these signals can be logic signals normally taking a *low* value (e.g., $\approx 0V$) and taking a *high* value (e.g., $\approx 3,3V$), if it is determined that the electric line 100 operates in a fault condition, or vice-versa.

According to the invention, the electronic stage 3 comprises a signal processing unit 30 configured to process the detection signal $V(t)$ and, possibly, determine whether the electric line 100 is subject to an earth leakage fault based on the behaviour of the detection signal $V(t)$.

The signal processing unit 30 includes digital processing resources, which are capable of executing software programmes, modules, routines, and/or instructions, and the like to carry out the foreseen functionalities. Such functionalities include the functionalities described in the following and, possibly, other functionalities that are here not described as of no interest for the purposes of the invention.

Advantageously, the signal processing unit 30 may be a microcontroller, a DSP, or a similar signal processing device.

Preferably, the electronic stage 3 comprises a front-end unit 31 configured to receive and process analogically the detection signal $V(t)$ from the detection stage 2 before the further processing operations carried out by the signal processing unit 30.

Preferably, the front-end unit 31 is adapted to amplify the detection signal $V(t)$ to rescale it to voltage levels compatible with the signal processing unit 30.

According to some embodiments of the invention, the front-end unit 31 is configured to filter with a low-pass analog filter the detection signal $V(t)$ to cut spurious high-frequency components of the detection signal.

In general, the front-end unit 31 may comprise electronic circuits of conventional type. As an example, it may include an operational circuit configured to amplify the detection signal and a filtering circuit to cut spurious high-frequency components of the detection signal $V(t)$.

According to preferred embodiments of the invention (as shown in the cited figures), the signal processing unit 30 is capable of directly generating the above-mentioned monitoring signal M, trip signal $T$ or alarm signal $A$.

According to other embodiments of the invention (not shown), however, the electronic stage 3 may comprise an output unit configured to receive a control signal (e.g., a trigger signal or an enabling signal) from the signal processing unit 30 and generate the above-mentioned monitoring signal $M$, trip signal $T$ or alarm signal $A$.

The electronic protection device 1 may obviously include additional stages and/or circuits and/or components in addition to those described above. These elements are here not described as they are of no actual interest for the purposes of the invention.

An essential aspect of the claimed invention consists in that the signal processing unit 30 is configured to carry out innovative signal processing functionalities to process the detection signal $V(t)$ and, possibly, determine whether the electric line 100 is subject to an earth leakage fault based on the behaviour of the detection signal $V(t)$.

As it will better emerge from the following, such signal processing functionalities are simple and effective and can be implemented also by a low-cost digital processing unit (e.g., a microcontroller) having a relatively low power consumption. Obviously, this ensures achieving outstanding performances for the residual current device and, at the same time, overcoming the above-mentioned drawbacks of similar devices of the state of the art.

According to the invention, the signal processing unit 30 is configured to calculate a first digital signal $V_n$ by carrying out an analog-to-digital conversion of the detection signal $V(t)$.

The first digital signal $V_n$ includes a first sequence of sampled values $V(n)$ (numeric values) of the detection signal $V(t)$.

Therefore, also the first digital signal $V_n$ is indicative of the instantaneous trend of the residual current $I_F$, i.e. of the magnitude of the residual current over time. Obviously, the first digital signal $V_n$ may have an offset value that may be set as explained above in relation to the detection signal $V(t)$.

The first digital signal $V_n$ can be easily obtained by sampling the detection signal $V(t)$ through sampling techniques of known type, which are here not described for the sake of brevity.

Preferably, the detection signal $V(t)$ is sampled at a predefined sampling frequency $f_s$ quite higher (preferably much higher) than the mains frequency $f_m$ (50 or 60 Hz), for example 2500 Hz.

Figure 2 shows an example of first digital signal $V_n$ obtained by sampling a detection signal $V(t)$ having a sinusoidal waveform with an offset value $V_0$. As it is possible to notice, the first digital signal $V_n$ clearly follows the instantaneous trend of the detection signal $V(t)$.

According to some embodiments of the invention, the processing unit 30 is configured to preliminarily filter the first digital signal $V_n$ before further processing such a digital signal.

This solution can be advantageously adopted to cut the contribution of spurious high-frequency components of the detection signal $V(t)$ to the sampled values $V(n)$ of the first digital signal $V_n$, especially when a preliminary filtering of the detection signal $V(t)$ is not carried out at level of the front-end unit 31 of the electronic stage 3.

The first digital signal $V_n$ can be filtered through digital filtering techniques of known type, which are here not described for the sake of brevity.

According to the invention, the signal processing unit 30 is configured to calculate a second digital signal $x_n$ based on the first digital signal $V_n$.

The second digital signal $x_n$ includes a second sequence of numeric values $x(n)$, each of which is calculated based on a corresponding sampled value $V(n)$ of the first digital signal $V_n$.

Preferably, the numeric values $x(n)$ of the second digital signal $x_n$ are cyclically calculated with a first calculation frequency $f_{1c}$ lower than or equal to the sampling frequency $f_s$ of the first digital signal $V_n$. Obviously, this means that the second digital signal $x_n$ may have less or equal numeric values compared to the first digital signal $V_n$.

Preferably, the numeric values $x(n)$ of the second digital signal $x_n$ are cyclically calculated with a first calculation frequency $f_{1c}$ higher (preferably much higher) than the mains frequency $f_m$.

More preferably, the first calculation frequency $f_{1c}$ is at least 10 times higher than the mains frequency $f_m$. In practice, the first calculation frequency is: $f_{1c} > 10\, f_m$.

As it will be apparent in the following, this solution is particularly advantageous since it allows computing other relevant digital signals at a suitably high frequency.

Each numeric value $x(n)$ of the second digital signal $x_n$ is calculated as the square of a difference value between a corresponding sampled value $V(n)$ of the first digital signal $V_n$ and the offset value $V_o$ of the first digital signal $V_n$.

In practice, a generic numeric value $x(n)$ of the second digital signal $x_n$ can be calculated according to the following relation:

$$x(n) = (V(n) - V_o)^2$$

where $V(n)$ is a corresponding sampled value of the first digital signal $V_n$ and is the above-mentioned offset value of the detection signal $V_n$.

The reasoning behind the calculation of the second discrete signal $x_n$ are briefly explained in the following.

As is known, a generic signal $V(t)$ variable in time can be written a superposition of harmonic components as:

$$V(t) = V_{OFF} + \sum_{n=1}^{+\infty} a_n \cos(w_n t + \varphi_n)$$

where $a_n$ are amplitude coefficients of the harmonic components, $w_n$ are positive angular frequencies $w_n = 2\pi f_n > 0$ of the harmonic components, and $\varphi_n$ are phase coefficients of the harmonic components.

Typically, for a periodic signal, the above-mentioned frequencies $f_n$ are multiple of a fundamental frequency $f_1$, which may be the mains frequency (50Hz or 60Hz) or higher. The overall periodicity is defined by a period $T = 1/f_1 = 2\pi/w_1$.

By squaring the above-mentioned signal $V(t)$ after removing its offset component, the following relationship is obtained:

$$(V(t) - V_{OFF})^2 = \sum_{n,m=1}^{+\infty} a_n a_m \cos(w_n t + \varphi_n) \cos(w_m t + \varphi_m) =$$

$$= \sum_{n,m=1}^{+\infty} \frac{a_n a_m}{2} \left[ \cos\big((w_n - w_m)t + (\varphi_n - \varphi_m)\big) \right.$$

$$\left. + \cos\big((w_n + w_m)t + (\varphi_n + \varphi_m)\big) \right]$$

(note that the well-known Werner identity: $\cos \alpha \cos \beta = [\cos(\alpha - \beta) + \cos(\alpha + \beta)]/2$ has been applied).

The DC component of the above-mentioned signal $(V(t) - V_{OFF})^2$ can be obtained if $(w_n - w_m) = 0$ that is by imposing $n = m$ in the above equation as the term $(w_n + w_m)$ is strictly positive.

The above-mentioned signal $(V(t) - V_{OFF})^2$ can therefore be written as:

$$(V(t) - V_{OFF})^2 = \left( \sum_{n=1}^{+\infty} \frac{a_n^2}{2} \right) + ACcomponents(t)$$

where the term AC *components(t)* is indicative of sinusoidal functions with frequency an integer multiple of the fundamental frequency $f_1$ (equal or higher).

The RMS square value of the above-mentioned signal $(V(t) - V_{OFF})^2$ is just represented by its DC component that can be written as:

$$V_{RMS}^2 \equiv \frac{1}{T} \int_0^T (V(t) - V_{OFF})^2 \, dt = \frac{1}{T} \int_0^T \left( \sum_{n=1}^{+\infty} \frac{a_n^2}{2} + \text{ACcomponents}(t) \right) dt$$

$$= \sum_{n=1}^{+\infty} \frac{a_n^2}{2}$$

The above-mentioned signal $(V(t) - V_{OFF})^2$ can therefore be written as:

$$(V(t) - V_{OFF})^2 = V_{RMS}^2 + ACcomponents(t).$$

If the above-illustrated reasoning is applied to the first digital signal $V_n$, each numeric value $x(n)$ of the second digital signal $x_n$ can be written as:

$$x(n) = (V(n) - V_0)^2 = V_{RMS}^2 + ACcomponents(n)$$

where $V(n)$, and $V_{RMS}^2$ are respectively a corresponding sampled value, the above-mentioned offset value, and the squared RMS value of the first digital signal $V_n$.

In general terms, the second digital signal $x_n$ is thus indicative of the sum of the squared RMS value $V_{RMS}^2$ and suitable AC components of the first digital signal $V_n$.

Being dependent on the squared RMS value $V_{RMS}^2$ of the first digital signal $V_n$, the second digital $x_n$ is indicative of the RMS value of the detected residual current $I_F$.

However, in the second digital signal $x_n$, the information related to the squared RMS value of the detected residual current $I_F$ is still overlapped with spurious information brought by the AC components of the first digital signal $V_n$ (i.e. of the residual current $I_F$).

Nonetheless, it is sufficient to suitably filter the second digital signal $x_n$ to obtain a specific quantity related to the detected residual current, which can be effectively used to determine whether the electric line 100 is subject to an earth leakage fault.

Figure 2 shows an example of the second digital signal $x_n$ obtained by processing the first digital signal $V_n$ as illustrated above. As it is possible to notice, the second digital signal $x_n$ signal has a variable magnitude that depends on the squared RMS value of the residual current $I_F$ and on the overlapped AC components of said residual current.

According to the invention, the signal processing unit 30 is configured to calculate a third digital signal $s_n$ based on the second digital signal $x_n$. The digital signal $s_n$ is calculated by filtering the second digital signal $x_n$ through a low-pass digital filter.

The third digital signal $s_n$ includes a third sequence of numeric values $s(n)$, each of which is calculated based on one or more corresponding numeric values $x(n)$ of the second digital signal $x_n$ and, possibly, on one or more numeric values of the third digital signal $s_n$, which have been previously calculated (for example at preceding calculation cycles).

Preferably, the numeric values $s(n)$ of the third digital signal $s_n$ are cyclically calculated with a second calculation frequency $f_{2c}$ lower than or equal to the sampling frequency $f_s$ of the first digital signal $V_n$. Obviously, this means that the third digital signal $s_n$ may have less or equal numeric values compared to the first digital signal $V_n$.

The second calculation frequency $f_{2c}$ of the numeric values $s(n)$ of the third digital signal $s_n$ may be lower than or equal to the first calculation frequency $f_{1c}$ of the numeric values $x(n)$ of the second digital signal $x_n$, which means that the third digital signal $s_n$ may have less or equal numeric values compared to the second digital signal $x_n$.

Preferably, the numeric values $s(n)$ of the third digital signal $s_n$ are cyclically calculated with a second calculation frequency $f_{2c}$ higher (preferably much higher) than the mains frequency $f_m$. More preferably, the second calculation frequency $f_{2c}$ is at least 10 times higher than the mains frequency $f_m$. In practice, the second calculation frequency is: $f_{2c} > 10 \, f_m$.

This solution is particularly advantageous since it provides the possibility to react quickly to sudden increases of the residual current. For instance, when there appears a very high residual current, a protection device must generate a trip signal within one or two periods of the mains, to satisfy requirements by standards. Computing filtered digital signals at a frequency much higher than the mains allows generating a trip signal T (or an alarm signal A) practically at any instant, without the need to wait until the end of the residual current waveform as it occurs for the algorithms currently used in the state of the art.

Another advantage of having a high computation frequency $f_{2c}$ for the third digital signal $s_n$ consists in that the algorithm can detect residual currents having a frequency content higher than the mains frequency without the need to introduce further routines or computations as it occurs in the solution disclosed in the cited patent EP2208271B 1, where a dedicated routine to compute the periodicity of the residual current is employed to manage these events.

With the proposed solution of the invention, it is therefore possible to design RCCBs or RCBOs of F-Type in a simple way and with low-cost microcontrollers.

Preferably, each numeric value $s(n)$ of the third digital signal $s_n$ is calculated by filtering the second digital signal $x_n$ through a low-pass digital filter, which is preferably a linear filter, more preferably an Infinite Impulse Response (IIR) digital filter.

The low-pass filtering of the second digital signal $x_n$ is a particularly simple calculation, which can be carried out with simple bit-shift operations in certain conditions.

As an example, a generic numeric value $s(n)$ of the third digital signal $s_n$ can be calculated according to the following relation:

$$s(n) = (1-a)s(n-1) + a\,x(n-1)$$

where $a$ is a positive number (which is advantageously much lower than 1).

As it is evident from the above, in this case, a generic value $s(n)$ of the third digital signal $s_n$ is calculated as a weighted sum of previously calculated values of the second and third digital signals $xn, sn$.

As it is evident also from the previous relation, for a IIR digital filter, few samples of the second and third digital signals $x_n$ and $s_n$ are necessary to obtain a suitable low-pass filtering. IIR filters therefore require few computations and are advantageous compared with other linear digital filters, like Finite Impulse Response (FIR) filters.

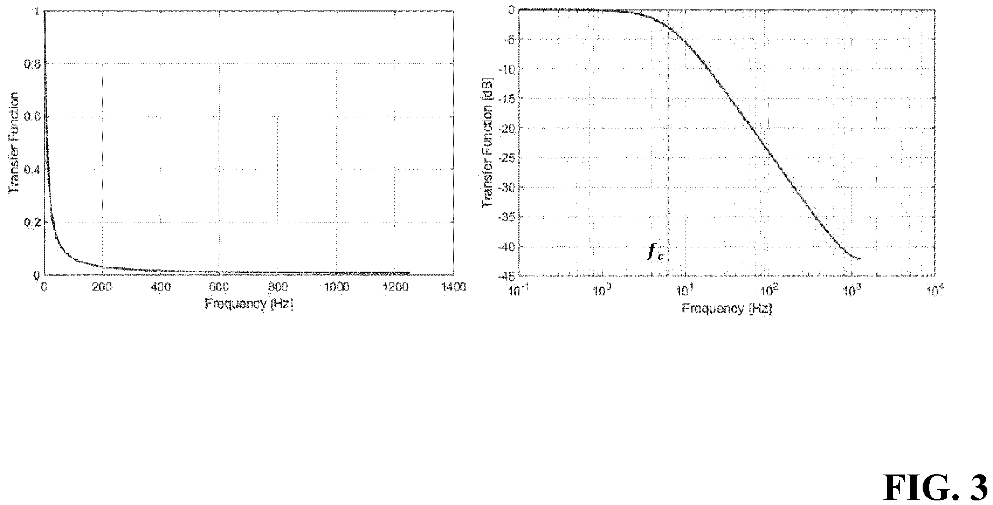

Figure 3 schematically shows the transfer function of the linear digital filter expressed by the above-mentioned exemplary relation, in which the sampling frequency of the first digital signal $V_n$ is $f_s$ = 2500 $Hz$ and the coefficient $a$ is selected as $a = \frac{1}{2^6}$ .

As it is possible to notice, the above-mentioned linear digital filter is a good low-pass filter, with a cut-off frequency $f_c \approx 6.3$ Hz much lower than the mains frequency.

Higher values of exponent $k$ for the parameter $a = 1/2^k$ would further reduce the cutoff frequency $f_c$, thus ensuring an improved filtering of the AC components of the second digital signal $x_n$. However, this would probably slow down the response of the third digital signal $s_n$, particularly when the residual current $I_F$ is subject to sudden increase.

It is evident how the above-mentioned filtering calculations can be carried out through simple bit-shift operations, if the above-mentioned coefficient $a$ is carefully selected, for example as $a = 1/2^k$.

This solution is quite advantageous as it allows carrying out the above-mentioned filtering step without division operations that are generally quite heavy from a computational point of view. Being the result of a low-pass filtering of the second digital signal $x_n$, the third digital signal $s_n$ is advantageously indicative of the squared RMS value $V_{RMS}^2$ of the first digital signal $V_n$, thereby being indicative of the squared RMS value of the detected residual current $I_F$, as explained above.

Figure 2 shows an example of the third digital signal $s_n$ obtained by processing the first and second digital signals $V_n, x_n$ as illustrated above. As it is possible to notice, the third digital signal $x_n$ converges quickly towards the squared RMS value $V_{RMS}^2$ of the first digital signal $V_n$, which is indicative of the squared RMS value of the detected residual current $I_F$.

As mentioned above, according to some embodiments of the invention, the electronic stage 3 is adapted to provide a monitoring signal $M$ indicative of the detected residual current $I_F$. Such a monitoring signal may be the third digital signal $s_n$ provided by the signal processing unit 30 or a signal that may be easily obtained by suitably processing in a known manner the third digital signal $s_n$ by the signal processing unit 30 or a possible output unit operatively coupled thereto.

As mentioned above, according to other embodiments of the invention, the signal processing unit 30 is adapted to determine when the electric line 100 is subject to a fault condition (earth leakage fault). In this case, each value $s(n)$ of the third digital signal $s_n$ provided by the signal processing unit 30 can be effectively used as a parameter to determine whether the electric line 100 is subject to an earth leakage fault.

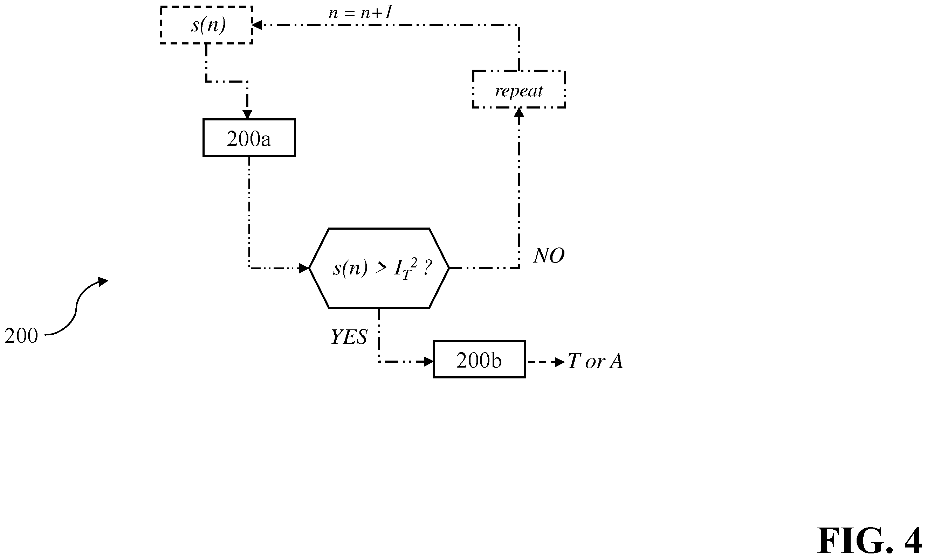

In order to determine whether the electric line 100 is subject to an earth leakage fault, according to some variants, the signal processing unit 30 cyclically carries out a first determination procedure 200 (figure 4) for each calculated value $s(n)$ of the third digital signal $s_n$.

The determination procedure 200 comprises a step 200a of comparing the value $s(n)$ of the third digital signal $s_n$ with a predefined threshold value $I_T^2$.

Preferably, the above-mentioned threshold value $I_T^2$ is calculated as the square of a RMS threshold value $I_T$, which is set for the residual current $I_F$ in view of the technical standards of the electronic protection device.

As each numeric value $s(n)$ of the third digital signal $s_n$ depends on the squared RMS value of the residual current $I_F$, comparing a numeric value $s(n)$ of the third digital signal $s_n$ with the predefined threshold value $I_T^2$ is equivalent to compare the RMS value of the residual current $I_F$ with the corresponding threshold value $I_T$.

This solution apparently reduces the computational load of the signal processing unit 30 as square root calculations of the values $s(n)$ of the third digital signal $s_n$ are not needed.

If the value $s(n)$ of the third digital signal $s_n$ exceeds the threshold value $I_T^2$, the signal processing unit 30 determines (step 200b) that the electric line 100 is subject to an earth leakage fault. In this case, the determination procedure 200 is terminated.

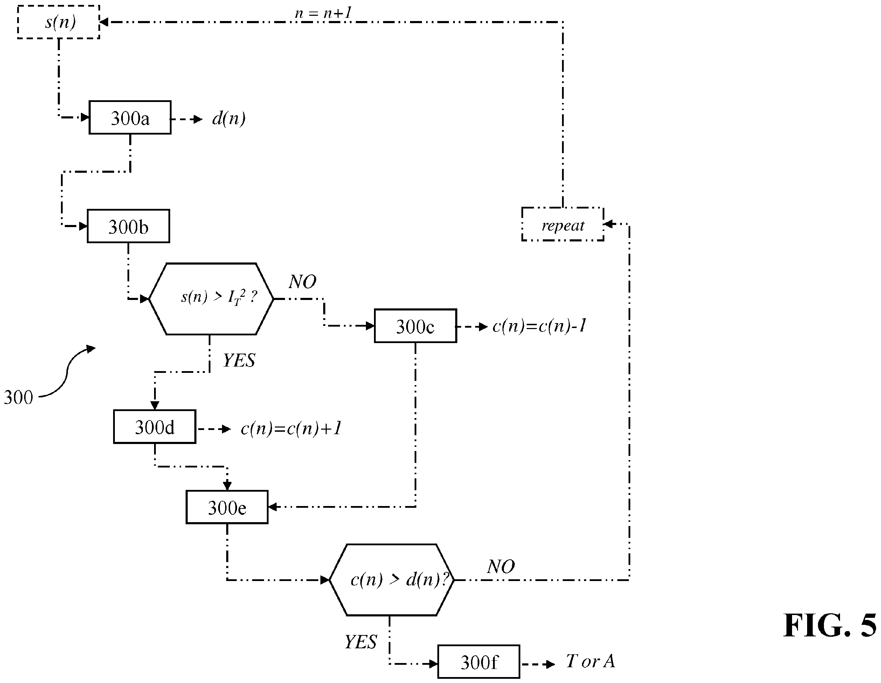

If the value $s(n)$ of the third digital signal $s_n$ does not exceed the threshold value $I_T^2$, the signal processing unit 30 determines that the electric line 100 is not subject to an earth leakage fault. In this case, the determination procedure 200 is repeated for a subsequent value $s(n+1)$ of the third digital signal $s_n$ at a subsequent execution cycle of said determination procedure. According to other (preferred) variants, the signal processing unit 30 carries out a more refined second determination procedure 300 (figures 2, 5 and 6) for each calculated value $s(n)$ of the third digital signal $s_n$.

The determination procedure 300 comprises a step 300a of setting a threshold value $d(n)$ depending on the numeric value $s(n)$ of the third digital signal $s_n$, which is taken into consideration.

Preferably, the set threshold value $d(n)$ is the value of a variable threshold function $d_n$, which corresponds to the numeric value $s(n)$ of the third digital signal $s_n$.

The variable threshold function $d_n$ is calculated based on the third digital signal $s_n$ and it can be advantageously used to adjust the tripping time of the electronic protection device 1 depending on the numeric values $s(n)$ taken by the third digital signal $s_n$, i.e. as a function of the squared RMS value of the residual current $I_F$.

The variable threshold function $d_n$ can thus be used to design a refined characteristic tripping curve of the electronic protection device 1. For example, the tripping times of the protection device can be reduced selectively to cope with particularly critical situations and, at the same time, satisfy the technical standards.

Preferably, the variable threshold function $d_n$ is a decreasing function simple to be computed. As an example, the variable threshold function $d_n$ can be defined as:

$$d_n = \begin{cases} D_{max} & \text{if} & s_n \leq I_T^2 \\ D_1 - \dfrac{s_n}{2^{r_1}} & \text{if} & I_T^2 < s_n \leq I_{mid}^2 \\ D_2 - \dfrac{s_n}{2^{r_2}} & \text{if} & I_{mid}^2 < s_n \leq I_{max}^2 \\ D_{min} & \text{if} & I_{max}^2 < s_n \end{cases}, \qquad (1)$$

where the parameters $D_{max}$, $D_1$, $D_2$, $D_{min}$, $r_1$, $r_2$, $I_T$, $I_{mid}$, $I_{max}$ are suitably chosen in view of the installation needs of the electronic protection device and in such a way to be compliant with technical standards.

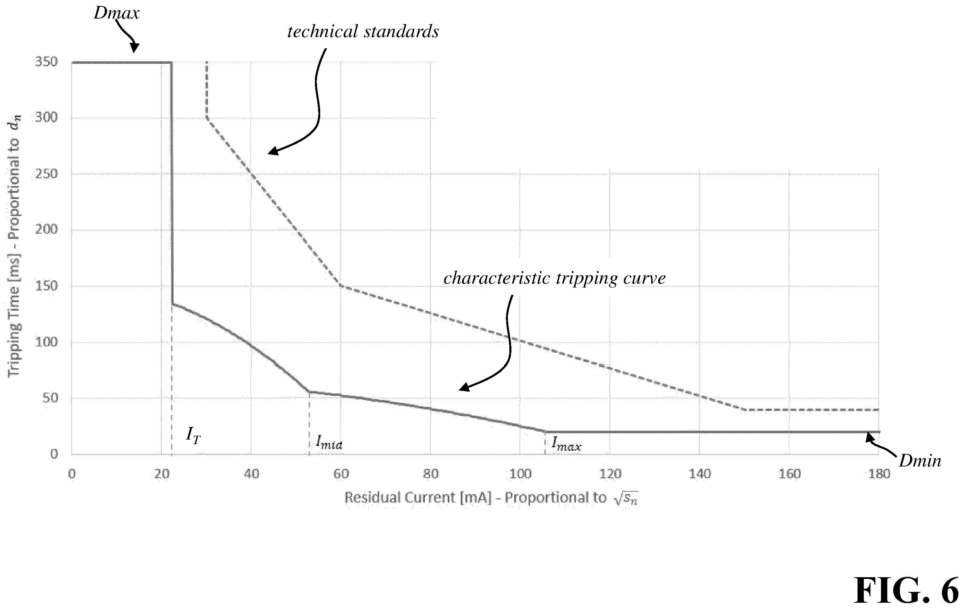

Figure 6 shows an example of characteristic tripping curve designed for the electronic protection device. As it is possible to observe, the variable threshold function $d_n$ is represented on the vertical axis while the variable $\sqrt{s_n}$, which depends on the RMS value of the residual current $I_F$, is represented on the horizontal axis.

The determination procedure 300 comprises a step 300b of comparing the numeric value $s(n)$ of the third digital signal $s_n$, which is taken into consideration, with a predefined threshold value $I_T^2$. Also in this case, the above-mentioned threshold value $I_T^2$ is preferably calculated as the square of a threshold value $I_T$ set for the detected residual current $I_F$.

Preferably, if the value $s(n)$ of the third digital signal $s_n$ does not exceed the threshold value $I_T^2$, the determination procedure 300 comprises a step 300c of decreasing an integer counter value $c(n)$, if said counter value is not null.

In this case, the signal processing unit 30 may directly determine that the electric line 100 is not subject to an earth leakage fault. The determination procedure 300 will then be repeated for a subsequent value $s(n+1)$ of the third digital signal $s_n$.

As an alternative, the signal processing unit 30 may proceed to carry out the step 300e of the determination procedure 300 as explained in the following.

If the value $s(n)$ of the third digital signal $s_n$ exceeds the threshold value $I_T^2$, the determination procedure 300 comprises a step 300d of increasing an (integer) counter value $c(n)$.

The determination procedure 300 comprises a step 300e of comparing the counter value $c(n)$ with the threshold value $d(n)$ calculated based on the value $s(n)$ of the third digital signal $s_n$.

If the counter value $c(n)$ exceeds the calculated threshold value $d(n)$, the signal processing unit 30 determines (step 300f) that the electric line 100 is subject to an earth leakage fault. In this case, the determination procedure 300 is terminated.

If the counter value $c(n)$ does not exceed the calculated threshold value $d(n)$, the signal processing unit 30 determines that the electric line 100 is not subject to an earth leakage fault. In this case, the determination procedure 300 is repeated for a subsequent value $s(n+1)$ of the third digital signal $s_n$ at a subsequent execution cycle of said determination procedure.

As mentioned above, the electronic stage 3 (namely the signal processing unit 30, or a possible output unit operatively coupled thereto) generates a trip signal T or an alarm signal A, if the signal processing unit 30 determines that the electric line 100 is subject to an earth leakage fault. Otherwise, the signal processing unit 30 continues to operate as explained above.

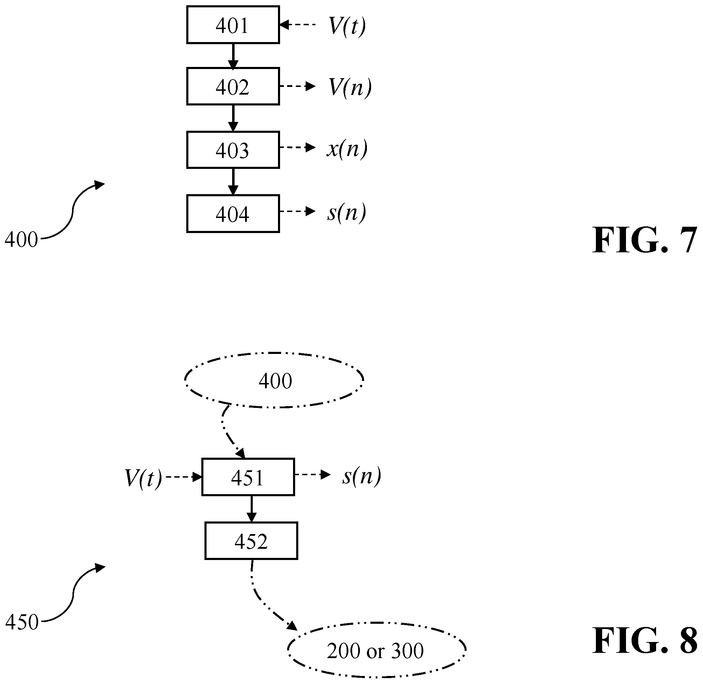

As it is apparent from the above, a further aspect of the present invention relates to a method 400 for detecting a residual current in an electric line 100 (figure 7).

The method 400, according to the invention, comprises:

- a step 401 of acquiring a detection signal $V(t)$ indicative of an instantaneous trend of a residual current $I_F$ between a plurality of conductors of the electric line 100;
- a step 402 of calculating a first digital signal $V(n)$ by carrying out an analog-to-digital conversion of the detection signal $V(t)$;
- a step 403 of calculating a second digital signal $x_n$ based on said first digital signal $V_n$. Each numeric value $x(n)$ of the second digital signal $x_n$ is calculated as the square of a difference value $V(n) - V_o$ between a corresponding sampled value $V(n)$ of the first digital signal $V_n$ and a predefined offset value $V_o$ of said first digital signal;
- a step 404 of calculating a third digital signal $s_n$ based on the second digital signal $x_n$. The third digital signal $s_n$ is calculated by filtering the second digital signal $x_n$ through a low-pass digital filter.

Preferably, the numeric values $x(n), s(n)$ of said second and third digital signals $x_n$, $s_n$ are cyclically calculated with a calculation frequency $f_{1c}$, $f_{2c}$ higher than the mains frequency $f_m$.

Preferably, the third digital signal $s_n$ is calculated by filtering said second digital signal $x_n$ through a low-pass IIR digital filter.

According to some embodiments of the invention, the method 400 comprises the step of preliminarily filtering the detection signal $V(t)$ through a low-pass digital filter before further processing said detection signal.

According to other embodiments of the invention, the method 400 comprises the step of preliminarily filtering the first digital signal $V_n$ through a low-pass digital filter before further processing said first digital signal.

According to a further aspect, the present invention relates to a method 450 for determining an earth leakage fault in an electric line 100 (figure 8).

The determination method 450 comprises a step 451 of carrying out the detection method 400, according to the invention, as described above.

The determination method 450 comprises a step 452 of determining whether the electric line 100 is subject to an earth leakage fault based on the third digital signal $s_n$ calculated through the detection method 400.

According to some embodiments of the invention, the determination step 452 of the determination method 450 includes carrying out the above-illustrated first determination procedure 200 for each calculated value $s(n)$ of the third digital signal $s_n$.

According to other embodiments of the invention, the determination step 452 of the determination method 450 includes carrying out the above-illustrated second determination procedure 300 for each calculated value $s(n)$ of the third digital signal $s_n$.

The residual current device, according to the invention, provides relevant advantages over similar solutions of the state of the art.

In the residual current device, according to the invention, the digital signal processing unit of the electronic stage is configured to carry out simple and effective signal processing functionalities to determine whether an electric line is subject to an earth leakage fault.

These signal processing functionalities do not require any analysis of the waveform of the detected residual current as in traditional solutions of the state of the art and can be implemented through simple calculations. Therefore, they can be implemented also by low-cost signal processing units (e.g., low-cost microcontrollers) having relatively low calculation power and power consumption. In this way, the digital signal processing unit of the electronic stage does not have a significant impact on the overall design and industrial costs of this latter.

The residual current device, according to the invention, can ensure an outstanding operating performance and high levels of flexibility and reliability.

The signal processing functionalities implemented by the digital signal processing unit of the electronic stage can be applied for a wide range of residual current frequencies and for multifrequency waveforms. They allow implementing advanced tripping strategies, which are quite effective in reducing undesired tripping manoeuvres of the electronic protection device, in which the residual current device is employed, and increasing EMC tolerance levels.

The residual current device of the invention is relatively simple to manufacture at industrial level, at competitive costs with respect to similar devices of the state of the art.

**Claims**

1. A residual current device (1) for low-voltage electrical systems, said residual current device comprising:

   - a detection stage (2) that, in operation, is coupled to an electric line, wherein said detection stage is configured to detect a residual current ($I_F$) in said electric line and provide a detection signal ($V(t)$) indicative of said residual current;
   - an electronic stage (3) configured to receive and process said detection signal ($V(t)$); **characterized in that** said electronic stage (3) comprises a signal processing unit (30) configured to:

     - calculate a first digital signal ($V_n$) by carrying out an analog-to-digital conversion of said detection signal ($V(t)$);
     - calculate a second digital signal ($x_n$) based on said first digital signal ($V_n$), each numeric value ($x(n)$) of said second digital signal being calculated as the square of a difference value between a corresponding sampled value ($V(n)$) and an offset value ($V_o$) of said first digital signal;
     - calculate a third digital signal ($s_n$) based on said second digital signal ($x_n$), said third digital signal being calculated by filtering said second digital signal through a low-pass digital filter.

2. Residual current device, according to claim 1, **characterised in that** the numeric values ($x(n)$, $s(n)$) of said second and third digital signals ($x_n$, $s_n$) are cyclically calculated with a calculation frequency ($f_{1c}$, $f_{2c}$) higher than the mains frequency.

3. Residual current device, according to one of the previous claims, **characterised in that** said third digital signal ($s_n$) is calculated by filtering said second digital signal ($x_n$) through a low-pass IIR digital filter.

4. Residual current device, according to one of the previous claims, **characterised in that** said electronic stage (3) comprises a front-end unit (31) configured to filter said detection signal ($V(t)$) before said detection signal is processed by said signal processing unit (30).

5. Residual current device, according to one of the claims from 1 to 3, **characterised in that** said processing unit (30) is configured to filter said first digital signal ($V_n$) before calculating said second digital signal ($x_n$).

6. Residual current device, according to one of the previous claims, **characterised in that** said electronic stage (3) is configured to determine whether said electric line (100) is subject to an earth leakage fault based on said third digital signal ($s_n$).

7. Residual current device, according to claim 6, **characterised in that** said electronic stage (3) is configured to carry out a determination procedure (300) including the following steps:

   - calculating (300a) a threshold value ($d(n)$) depending on said numeric value ($s(n)$);
   - comparing (300b) said numeric value ($s(n)$) with a predefined threshold value ($I_T^2$);
   - if said numeric value ($s(n)$) exceeds said predefined threshold value ($I_T^2$), increasing (300d) a counter value ($c(n)$); or
   - if said numeric value ($s(n)$) does not exceed said predefined threshold value ($I_T^2$), decreasing (300c) said counter value ($c(n)$), if said counter value is not null;
   - comparing (300e) said counter value ($c(n)$) with said threshold value ($d(n)$) calculated depending on said numeric value ($s(n)$);
   - if said counter value ($c(n)$) exceeds said threshold value ($d(n)$), determining (300f) that said electric line (100) is subject to an earth leakage fault;
   - if said counter value ($c(n)$) does not exceed said variable threshold value ($d(n)$), repeating the previous steps for another numeric value of said third digital signal ($s_n$) at a subsequent execution cycle of said determination procedure (300).

8. Residual current device, according to claim 6, **characterised in that** said electronic stage (3) is configured to carry out a determination procedure (200) including the following steps:

   - comparing (200a) said numeric value $s(n)$ with a predefined threshold value ($I_T^2$);
   - if said numeric value $s(n)$ exceeds said predefined threshold value ($I_T^2$), determining (200b) that said electric line (100) is subject to an earth leakage fault;

- if said numeric value $s(n)$ does not exceed said predefined threshold value ($I_T^2$), repeating the previous steps for another numeric value of said third digital signal ($s_n$) at a subsequent execution cycle of said determination procedure (200).

9. An electronic protection device, **characterised in that** it comprises a residual current device (1), according to one of the previous claims.

10. An electronic protection device, according to claim 9, **characterised in that** it is a RCCB, or a RCBO for low-voltage electrical systems.

11. An electronic monitoring device, **characterised in that** it comprises a residual current device (1), according to one of the claims from 1 to 8.

12. A method (400) for detecting a residual current in an electric line (100), **characterized in that** it comprises the following steps:

- acquiring (401) a detection signal ($V(t)$) indicative of a residual current ($I_F$) between a plurality of conductors of an electric line (100);
- calculating (402) a first digital signal ($V_n$) by carrying out an analog-to-digital conversion of said detection signal (V(t));
- calculating (403) a second digital signal ($x_n$) based on said first digital signal ($V_n$), each numeric value ($x(n)$) of said second digital signal being calculated as the square of a difference value between a corresponding sampled value ($V(n)$) and an offset value ($V_o$) of said first digital signal;
- calculating (404) a third digital signal ($s_n$) based on said second digital signal ($x_n$), said third digital signal being calculated by filtering said second digital signal through a low-pass digital filter.

13. Method, according to claim 12, **characterised in that** the numeric values ($x(n)$, $s(n)$) of said second and third digital signals ($x_n$, $s_n$) are cyclically calculated with a calculation frequency higher than the mains frequency.

14. Method, according to one of the claims from 11 to 12, **characterised in that** said third digital signal ($s_n$) is calculated by filtering said second digital signal ($x_n$) through a low-pass IIR digital filter.

15. A method (450) for determining the presence of an earth leakage fault in an electric line (100) **characterized in that** it comprises the following steps:

- carrying out (451) a detection method (400), according to one of the claims from 12 to 14;
- determining (452) whether said electric line (100) is subject to an earth leakage fault based on the third digital signal ($s_n$) calculated through said detection method.

16. Method, according to claim 15, **characterised in that** said step (452) of determining that said electric line (100) is subject to an earth leakage fault includes carrying out, for each numeric value *(s(n))* of said third digital signal ($s_n$), a determination procedure (300) including the following steps:

- calculating (300a) a threshold value *(d(n))* depending on said numeric value *(s(n))*;
- comparing (300b) said numeric value *(s(n))* with a predefined threshold value ($I_T^2$);
- if said numeric value *(s(n))* exceeds said predefined threshold value ($I_T^2$), increasing (300d) a counter value *(c(n))*; or
- if said numeric value *(s(n))* does not exceed said predefined threshold value ($I_T^2$), decreasing (300c) said counter value *(c(n))*, if said counter value is not null;
- comparing (300e) said counter value *(c(n))* with said threshold value *(d(n))* calculated depending on said numeric value *(s(n))*;
- if said counter value *(c(n))* exceeds said threshold value *(d(n))*, determining (300f) that said electric line (100) is subject to an earth leakage fault;
- if said counter value *(c(n))* does not exceed said variable threshold value *(d(n))*, repeating the previous steps for another numeric value of said third digital signal ($s_n$) at a subsequent execution cycle of said determination procedure.

**17.** Method, according to claim 15, **characterised in that** said step (452) of determining that said electric line (100) is subject to an earth leakage fault includes carrying out, for each numeric value *(s(n))* of said third digital signal $(s_n)$, a determination procedure (200) including the following steps:

- comparing (200a) said numeric value *s(n)* with a predefined threshold value $(I_T^2)$;
- if said numeric value *s(n)* exceeds said predefined threshold value $(I_T^2)$, determining (200b) that said electric line (100) is subject to an earth leakage fault;
- if said numeric value *s(n)* does not exceed said predefined threshold value $(I_T^2)$, repeating the previous steps for another numeric value of said third digital signal $(s_n)$ at a subsequent execution cycle of said determination procedure (200).

# FIG. 1

**FIG. 1A**

FIG. 2

$f_m << f_s$  |  $f_m << f_{1c} <= f_s$  |  $f_m << f_{2c} <= f_{1c} <= f_s$

EP 4 782 859 A1

FIG. 3

FIG. 4

FIG. 5

FIG. 6

EP 4 782 859 A1

```
                  ┌─────────┐
          V(t) ----▶│   401   │
                  └─────────┘
                       │
                       ▼
                  ┌─────────┐
                  │   402   │----▶ V(n)
                  └─────────┘
                       │
                       ▼
                  ┌─────────┐
                  │   403   │----▶ x(n)
                  └─────────┘
                       │
                       ▼
                  ┌─────────┐
     400          │   404   │----▶ s(n)
                  └─────────┘
```

**FIG. 7**

```
                 ⌈‾‾‾‾‾‾‾‾‾‾⌉
                (    400    )
                 ⌊_____⌋
                       .
                       ▼
                  ┌─────────┐
        V(t) ----▶│   451   │----▶ s(n)
                  └─────────┘
                       │
                       ▼
                  ┌─────────┐
     450          │   452   │
                  └─────────┘
                       .
                       ▼
                 ⌈‾‾‾‾‾‾‾‾‾‾‾‾⌉
                ( 200 or 300 )
                 ⌊_____⌋
```

**FIG. 8**

**EUROPEAN SEARCH REPORT**

Application Number

EP 25 15 3719

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/220422 A1 (JACKSON KEITH [GB]) 2 September 2010 (2010-09-02) | 1-3,5,6, 8-15,17 | INV. G01R31/52 |
| Y | * the whole document * | 4,7,16 | H02H3/33 |
| | ----- | | |
| Y | US 10 790 659 B1 (LEE TOM LIK-CHUNG [US]) 29 September 2020 (2020-09-29) | 4 | ADD. H02H1/00 |
| A | * columns 5-6; figure 2 * | 1-3,5-17 | |
| | ----- | | |
| Y | US 11 605 943 B2 (ABB SCHWEIZ AG [CH]) 14 March 2023 (2023-03-14) | 7,16 | |
| A | * columns 6-9; figures 2, 4 * | 1-6, 8-15,17 | |
| | ----- | | |
| A | US 10 427 550 B2 (SIEMENS AG [DE]) 1 October 2019 (2019-10-01) * figure 2 * | 1-17 | |
| | ----- | | |

**TECHNICAL FIELDS SEARCHED (IPC)**

H02H
G01R

The present search report has been drawn up for all claims

| Place of search | Date of completion of the search | Examiner |
|---|---|---|
| Munich | 18 June 2025 | Gomes Guerreiro, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 15 3719

This annex lists the patent family members relating to the patent documents cited in the above-mentioned European search report.
The members are as contained in the European Patent Office EDP file on
The European Patent Office is in no way liable for these particulars which are merely given for the purpose of information.

18-06-2025

| Patent document cited in search report | | Publication date | Patent family member(s) | | Publication date |
|---|---|---|---|---|---|
| US 2010220422 | A1 | 02-09-2010 | AU | 2008306672 A1 | 09-04-2009 |
| | | | EP | 2243205 A1 | 27-10-2010 |
| | | | GB | 2455491 A | 17-06-2009 |
| | | | US | 2010220422 A1 | 02-09-2010 |
| | | | WO | 2009044111 A1 | 09-04-2009 |
| US 10790659 | B1 | 29-09-2020 | CA | 3112609 A1 | 26-12-2021 |
| | | | EP | 3929599 A1 | 29-12-2021 |
| | | | US | 10790659 B1 | 29-09-2020 |
| US 11605943 | B2 | 14-03-2023 | NONE | | |
| US 10427550 | B2 | 01-10-2019 | CN | 107800163 A | 13-03-2018 |
| | | | DE | 102016216401 A1 | 01-03-2018 |
| | | | US | 2018056802 A1 | 01-03-2018 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2208271 B